# EUROPÄISCHE PATENTANMELDUNG

(11) **EP 0 758 770 A1**
(43) Veröffentlichungstag der Anmeldung: **19.02.1997**
(21) Anmeldenummer: 96112631.5
(22) Anmeldetag: 05.08.1996
(51) Int. Cl.: G06F 5/06

(54) **Verfahren und Schaltungsanordnung zur Resynchronisation einer Speicherverwaltung**

(30) Priorität: 14.08.1995 DE 19529966
(71) Anmelder: DEUTSCHE THOMSON-BRANDT GMBH, 78048 Villingen-Schwenningen (DE)
(72) Erfinder: Ostermann, Ralf, 30451 Hannover (DE)

(57) **Zusammenfassung**

Häufig werden FIFO(First-In-First-Out) -Speicher als autonome Systeme realisiert, bei denen die Schreib- und Lesezeiger von außen nicht zugänglich sind und lediglich eine Möglichkeit zum Anlegen eines Rücksetzsignals vorhanden ist. Wenn bei diesen Speichern einer der beiden Zeiger fälschlicherweise inkrementiert wurde, kann dieser Fehler von außen weder erkannt noch korrigiert werden. Um zumindestens die Dauer des Fehlers zu begrenzen, können zwar die Schreib- und Lesezeiger periodisch zurückgesetzt werden, dieses Verfahren kann jedoch nur angewendet werden, wenn die Struktur des Eingangsdatenstromes genügend große Lücken aufweist. Erfindungsgemäß wird stattdessen eine Löschung des eventuell noch vorhandenen Inhaltes des FIFO-Speichers durch die Resynchronisation dadurch verhindert, daß bei jedem Eingangssynchronisationssignal (IS) eine Sicherung des aktuellen Schreibzeigerinhaltes (SP) bzw. eine Markierung der zum Zeitpunkt des Eingangssynchronisationssignals geschriebenen Daten erfolgt. Der FIFO-Speicher wird dann, sobald alle Daten eines Synchronisationsblocks ausgelesen wurden, durch ein Ausgangssynchronisationssignals (OS) zum Auslesen des nächsten Synchronisationsblocks veranlaßt, wobei der Lesezeiger mit dem Wert des zuvor gesicherten Schreibzeigers geladen wird. Damit werden die Positionen des Schreib- und des Lesezeigers mit jedem Synchronisationsblock neu abgeglichen.

## Beschreibung

Die Erfindung betrifft ein Verfahren und eine Schaltungsanordnung zur Resynchronisation einer Speicherverwaltung, die insbesondere bei FIFO(First-In-First-Out)- Speichern Anwendung findet.

### Stand der Technik

FIFO-Speicher werden mit Hilfe von Speicherregistern und einer speziellen Adressierlogik realisiert, wobei die Adressierlogik im wesentlichen einen Schreib- und einen Lesezeiger enthält. Diese Zeiger werden bei jedem Schreib- und / oder Lesezugriff inkrementiert. Im Falle eines zyklischen FIFO-Speichers werden die beiden Zeiger nach jeder Inkrementoperation zusätzlich einer Modulooperation unterzogen.

Häufig werden FIFO-Speicher als autonome Systeme realisiert, bei denen die Schreib- und Lesezeiger von außen nicht zugänglich sind und lediglich eine Möglichkeit zum Anlegen eines Rücksetzsignals vorhanden ist. Wenn bei diesen Speichern einer der beiden Zeiger fälschlicherweise inkrementiert wurde, kann dieser Fehler von außen weder erkannt noch korrigiert werden.

### Erfindung

Der Erfindung liegt die Aufgabe zugrunde, ein Verfahren zur Resynchronisation von seriellen Speichern, insbesondere von FIFO-Speichern, anzugeben, das keine speziellen Anforderungen an die zeitliche Folge der Eingangsdaten stellt und bei Beibehaltung der vollen FIFO-Speicherkapazität eine hohe Fehlertoleranz ermöglicht. Diese Aufgabe wird durch das in Anspruch 1 angegebene Verfahren gelöst.

Der Erfindung liegt die weitere Aufgabe zugrunde, eine Schaltungsanordnung zur Anwendung des erfindungsgemäßen Verfahrens anzugeben. Diese Aufgabe wird durch die in Anspruch 7 angegebene Schaltungsanordnung gelöst.

Die Dauer eines Fehlers, der durch die fälschliche Inkrementierung eines Zeigers verursacht wird, kann zwar begrenzt werden, indem die Schreib- und Lesezeiger periodisch zurückgesetzt werden. Da der FIFO-Speicherinhalt nach dem Zurücksetzen der Zeiger nicht mehr zur Verfügung steht und damit der eventuell noch vorhandene Inhalt des FIFO-Speichers gelöscht wird, kann dieses Verfahren jedoch nur angewendet werden, wenn die Struktur des Eingangsdatenstromes genügend große Lücken aufweist. Eine solche Datenstrukur zu verwenden ist jedoch oft nicht möglich oder nicht wünschenswert.

Im Prinzip besteht das erfindungsgemäße Verfahren zur Resynchronisation einer Speicherverwaltung, bei der eine serielle Speicherung der Daten erfolgt, nun darin, daß zum Zeitpunkt eines Synchronisationssignales eine Markierung von Daten oder eine Sicherung von Datenadressen erfolgt und diese markierten Daten oder gesicherten Datenadressen zu einem späteren Zeitpunkt für die Resynchronisation verwendet werden.

Vorteilhaft geben hierbei ein oder mehrere Schreib- und Lesezeiger die Datenadressen an, an welchen Schreib- und Lesezugriffe erfolgen, und es werden der oder die Schreibzeiger gesichert und zu einem späteren Zeitpunkt als Lesezeiger verwendet.

Hierbei sind vorzugsweise die Daten in Synchronisationsblöcken angeordnet und es wird dann der Lesezeiger mit dem Wert eines zuvor gesicherten Schreibzeigers geladen, wenn ein neuer Synchronisationsblock ausgelesen werden soll.

Zweckmäßigerweise wird der gesicherte Schreibzeiger als ungültig markiert, nachdem der Lesezeiger mit dem Wert dieses Schreibzeigers geladen worden ist.

Ebenso ist es zweckmäßig, beim Fehlen eines gesicherten Schreibzeigers das nächste Synchronisationssignal abzuwarten und die gespeicherten Daten zu ignorieren.

Besonders vorteilhaft kann auch sein, zur Markierung der Daten die Wortbreite um ein oder mehrere Bits zu erhöhen und in diesen Bits zu vermerken, ob beim Schreiben der zugehörigen Daten ein Synchronisationssignal vorlag.

Im Prinzip ist die erfindungsgemäße Schaltungsanordnung zur Resynchronisation einer Speicherverwaltung nach einem der Ansprüche 1 bis 7 versehen mit einem seriellen Speicher mit Speicherregistern zur Datenspeicherung sowie einem ersten Speicherbereich, in dem die Adresse des aktuellen Schreibzugriffs abgelegt ist, und einem zweitem Speicherbereich, in dem die Adresse des aktuellen Lesezugriffs abgelegt ist, wobei die Adressen bei Schreib- bzw. Lesezugriffen imkrementiert werden, darin, daß zum Zeitpunkt eines ersten Synchronisationssignals eine Markierung von Daten oder eine Sicherung von Datenadressen in einem dritten Speicherbereich erfolgt und diese markierten Daten oder gesicherten Datenadressen zum Zeitpunkt eines zweiten Synchronisationssignals für die Resynchronisation verwendet werden.

In einer weiteren Verbesserung sorgt ein Logikbaustein dafür, daß beim Vorliegen des ersten Synchronisationssignals die Adresse des aktuellen Schreibzugriffs in den dritten Speicherbereich zwischengespeichert wird und beim Vorliegen des zweiten Synchronisationssignals diese Adresse in den zweiten Speicherbereich eingelesen wird.

Vorzugsweise ist der dritte Speicherbereich zur Zwischenspeicherung der Adressen ebenfalls ein serieller Speicher.

Besonders vorteilhaft kann es auch sein, die Wortbreite des seriellen Speichers zur Markierung der Daten um ein oder mehrere Bits zu erhöhen und den Speicherregistern zur Datenspeicherung zusätzliche Register zuzuordnen, in denen vermerkt wird, ob beim Schreiben der zugehörigen Daten ein Synchronisationssignal vorlag.

### Zeichnungen

Anhand der Zeichnungen werden Ausführungsbeispiele der Erfindung beschrieben. Diese zeigen in:
- Fig. 1: ein Blockschaltbild einer erfindungsgemäßen Schaltungsanordnung mit Zwischenspeicherung,
- Fig. 2: ein Blockschaltbild einer Schaltungsanordnung gemäß Fig.1, wobei der Zwischenspeicher als FIFO-Speicher ausgebildet ist,
- Fig. 3: ein Blockschaltbild einer erfindungsgemäßen Schaltungsanordnung mit erhöhter Speicherwortbreite zur Datenmarkierung.

### Ausführungs-Beispiel

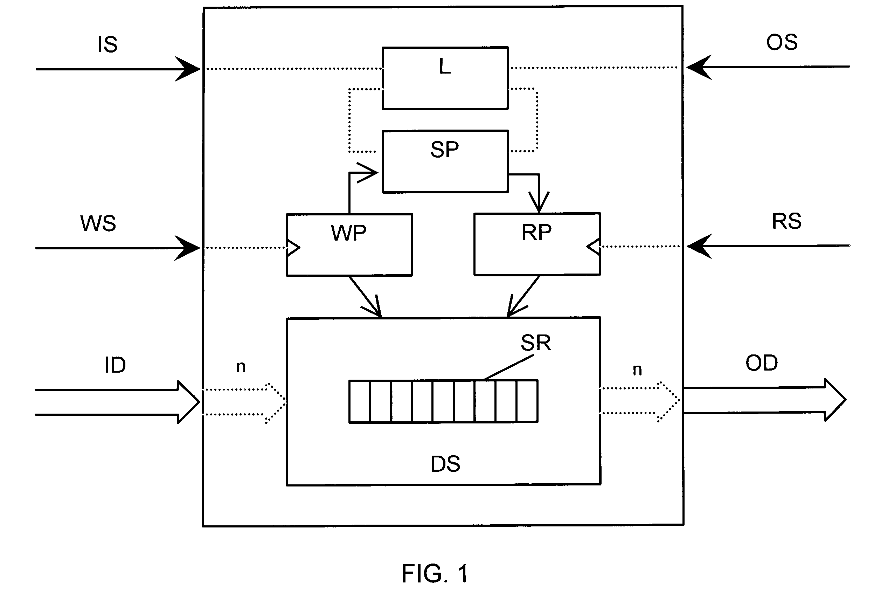

In Fig. 1 ist das Blockschaltbild einer erfindungsgemäßen Schaltungsanordnung zur Resynchronisation einer Speicherverwaltung, bei der eine serielle Speicherung der Daten erfolgt, dargestellt. Die zwischenzuspeichernden Daten werden über einen Eingang ID der Breite n in einen aus N Speicherregistern SR bestehenden seriellen Datenspeicher DS eingelesen, sodaß die Speicherkapazität N*n beträgt. Aus dem Datenspeicher DS werden die Daten später über einen Ausgang OD wieder ausgelesen. Weitere Register WP und RP beinhalten die Adressen des aktuellen Schreib- bzw. Lesezugriffs. Der Schreibzeiger WP wird hierbei bei jedem Schreibzugriff über den Anschluß WS inkrementiert, ebenso sorgt der Anschluß RS bei jedem Lesezugriff für eine Inkrementierung des Lesezeigers RP. Liegt nun am Eingang IS ein Eingangssynchronisationssignal an, so wird durch eine Synchronisationslogikeinheit L eine Zwischenspeicherung des Schreibzeigerinhaltes in einem weiteren Register SP veranlaßt. Beim Auslesen der in Synchronisationsblöcken angeordneten Daten aus den Speicherregistern DS wird dann durch ein Ausgangssynchronisationssignal OS dem FIFO-Speicher mitgeteilt, daß der aktuelle Synchronisationsblock vollständig ausgelesen worden ist und nun der nächste Synchronisationsblock ausgelesen werden soll. Das den Lesezeiger beinhaltende Register RP wird nun mit dem in dem Register SP zwischengespeicherten Schreibzeiger geladen, womit eine Resynchronisierung sichergestellt ist. Bis zum Auftreten des nächsten Eingangssynchronisationssignals kann dann der zuvor gesicherte Schreibzeiger als ungültig markiert werden. Ferner wird für den Fall, daß noch kein gültiger gesicherter Schreibzeiger vorhanden ist, daß nächste Eingangssynchronisationssignal abgewartet, wobei alle im FIFO-Speicher abgelegten Daten ignoriert werden können.

Die bis hier beschriebene Schaltungsanordnung kann insbesondere dann benutzt werden, wenn die Anzahl der Daten innerhalb eines Synchronisationsblockes größer ist als die Speichertiefe N des FIFO Speichers. Übersteigt die Speichertiefe des FIFO Speicher dagegen die Länge eines Synchronisationsblockes, so müssen mehrere Schreibzeiger zwischengespeichert werden.

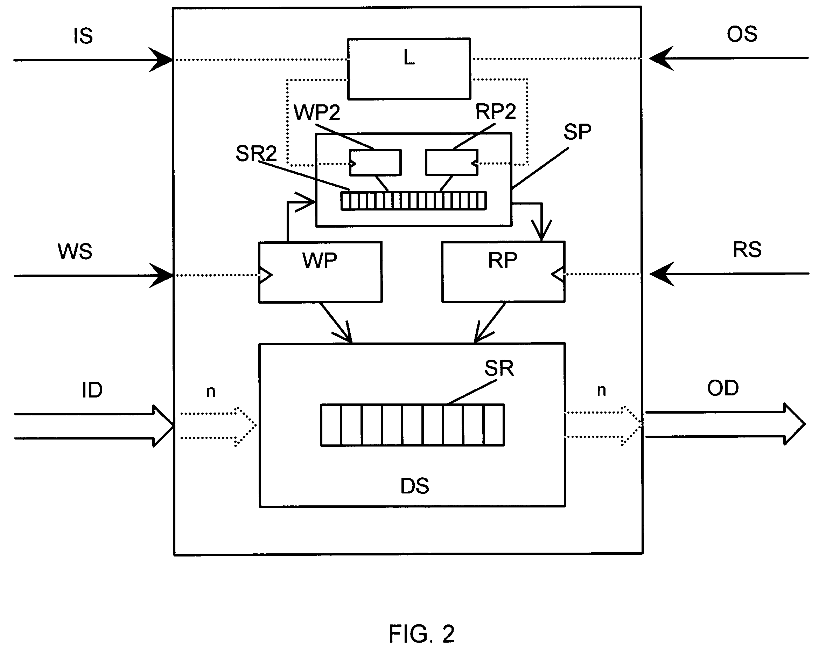

Hierfür kann, wie in Fig. 2 dargestellt, der Zwischenspeicher SP ebenfalls als FIFO-Speicher ausgebildet werden. Die Schreibzeiger werden nun in den Speicherregistern SR2 abgelegt. Dieses erfolgt jeweils, wenn ein Eingangssynchronisationssignal auftritt, wobei gleichzeitig der Schreibzeiger WP2 des Zwischenspeichers SP inkrementiert wird. Beim Auftreten eines Ausgangssynchronisationssignals wird dann der durch den Lesezeiger RP2 des Zwischenspeichers SP markierte Schreibzeiger ausgelesen und der Lesezeiger RP2 inkrementiert.

Statt einen weiteren FIFO Speicher zur Zwischenspeicherung der Schreibzeiger zu verwenden, kann durch eine Erhöhung der Wortbreite um ein oder mehrere zusätzliche Bits auch eine Markierung der Daten im Datenspeicher DS erfolgen.

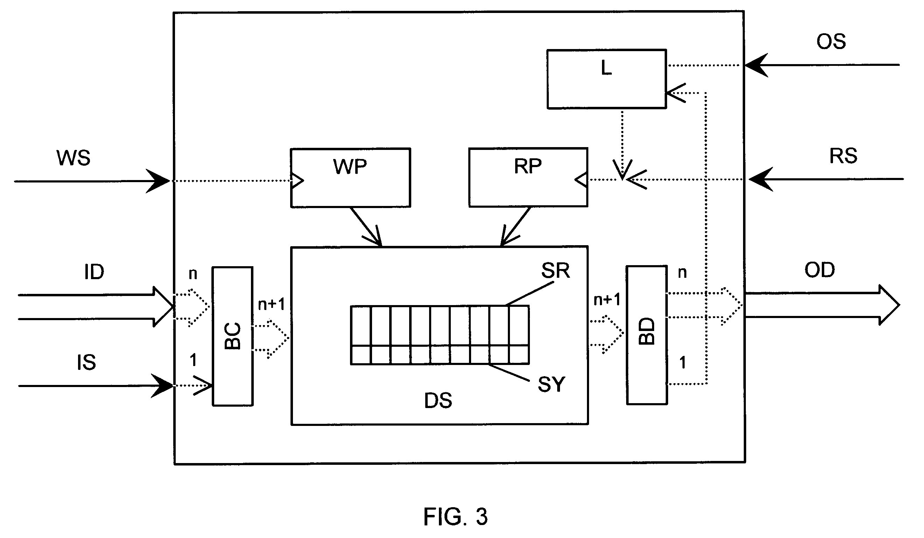

Ein solches Ausführungsbeispiel ist in Fig. 3 dargestellt. Die Daten werden über den Eingang ID eingelesen, das Eingangssynchronisationssignal über den Eingang IS. Die Daten haben hierbei eine Breite von n Bits, für das Eingangssynchronisationssignal genügt hier ein einzelnes Bit. Beide Signale werden in der Einheit BC kombiniert, so daß in den Datenspeicher DS jeweils n+1 Bits parallel eingelesen werden können. Damit kann für jeden Eintrag in den Datenspeicherregistern SR in den jeweils zugeordneten Registern SY vermerkt werden, ob beim Schreiben dieses Eintrags ein Eingangssynchronisationssignal vorlag. Werden die Daten dann aus dem Datenspeicher DS ausgelesen, so werden die N Datenbits sowie das Synchronisationsbit in einer weiteren Einheit BD wieder voneinander getrennt. Die n Datenbits werden dann über den Ausgang D ausgelesen, das Synchronisationsbit wird der Adressierlogikeinheit L zugeführt, um die Resynchronisation zu ermöglichen.

Neben der bisher in den Ausführungsbeispielen beschriebenen Hardware-Umsetzung des erfindungsgemäßen Verfahrens ist es natürlich auch möglich, das Verfahren als teilweise oder vollständige Software-Lösung zu implementieren.

Die Erfindung kann in den verschiedensten Anwendungen der digitalen Übertragungstechnik, insbesondere in Dekodern, benutzt werden. Exemplarisch seien genannt:
- die Verkopplung von digitalen Systemen, die mit unterschiedlichen Bitraten arbeiten, sogenannte asynchrone Schnittstellen,
- Verzögerungsschaltungen,
- Warteschlangen.

## Patentansprüche

1. Verfahren zur Resynchronisation einer Speicherverwaltung, bei der eine serielle Speicherung der Daten (DS) erfolgt, **dadurch gekennzeichnet,** daß zum Zeitpunkt eines Synchronisationssignales (IS) eine Markierung (SY) von Daten oder eine Sicherung von Datenadressen (SP) erfolgt und diese markierten Daten oder gesicherten Datenadressen zu einem späteren Zeitpunkt für die Resynchronisation verwendet werden.

2. Verfahren nach Anspruch 1, wobei ein oder mehrere Schreib-(WP) und Lesezeiger (RP) die Datenadressen angeben, an welchen Schreib- und Lesezugriffe erfolgen, und der oder die Schreibzeiger gesichert (SP) und zu einem späteren Zeitpunkt als Lesezeiger verwendet werden.

3. Verfahren nach Anspruch 2, wobei die Daten in Synchronisationsblöcken angeordnet sind und der Lesezeiger dann mit dem Wert eines zuvor gesicherten Schreibzeigers geladen wird, wenn ein neuer Synchronisationsblock ausgelesen werden soll.

4. Verfahren nach Anspruch 2 oder 3, wobei der gesicherte Schreibzeiger als ungültig markiert wird, nachdem der Lesezeiger mit dem Wert dieses Schreibzeigers geladen worden ist.

5. Verfahren nach einem der Ansprüche 2 bis 4, wobei beim Fehlen eines gesicherten Schreibzeigers das nächste Synchronisationssignal abgewartet wird und die gespeicherten Daten ignoriert werden.

6. Verfahren nach Anspruch 1, wobei zur Markierung der Daten die Wortbreite um ein oder mehrere Bits erhöht wird und in diesen Bits vermerkt wird, ob beim Schreiben der zugehörigen Daten ein Synchronisationssignal vorlag.

7. Schaltungsanordnung zur Resynchronisation einer Speicherverwaltung nach einem der Ansprüche 1 bis 6 mit einem seriellen Speicher (DS) mit Speicherregistern (SR) zur Datenspeicherung sowie einem ersten Speicherbereich (WP), in dem die Adresse des aktuellen Schreibzugriffs abgelegt ist, und einem zweitem Speicherbereich (RP), in dem die Adresse des aktuellen Lesezugriffs abgelegt ist, wobei die Adressen bei Schreib- bzw. Lesezugriffen imkrementiert werden (WS,RS), **dadurch gekennzeichnet,** daß zum Zeitpunkt eines ersten Synchronisationssignals (IS) eine Markierung von Daten oder eine Sicherung von Datenadressen in einem dritten Speicherbereich (SP) erfolgt und diese markierten Daten oder gesicherten Datenadressen zum Zeitpunkt eines zweiten Synchronisationssignals (OS) für die Resynchronisation verwendet werden.

8. Schaltungsanordnung nach Anspruch 7, wobei ein Logikbaustein (L) dafür sorgt, daß beim Vorliegen des ersten Synchronisationssignals (IS) die Adresse des aktuellen Schreibzugriffs in den dritten Speicherbereich (SP) zwischengespeichert wird und beim Vorliegen des zweiten Synchronisationssignals (OS) diese Adresse in den zweiten Speicherbereich eingelesen wird.

9. Schaltungsanordnung nach einem der Ansprüche 7 oder 8, wobei der dritte Speicherbereich (SP) zur Zwischenspeicherung der Adressen ebenfalls ein serieller Speicher ist.

10. Schaltungsanordnung nach einem der Ansprüche 7 bis 9, wobei die Wortbreite des seriellen Speichers (DS) zur Markierung der Daten um ein oder mehrere Bits erhöht wird und den Speicherregistern (SR) zur Datenspeicherung zusätzliche Register (SY) zugeordnet sind, in denen vermerkt wird, ob beim Schreiben der zugehörigen Daten ein erstes Synchronisationssignal (IS) vorlag.
